# EUROPEAN PATENT APPLICATION

(11) **EP 4 550 388 A1**
(43) Date of publication of application: **07.05.2025**
(21) Application number: 24181395.5
(22) Date of filing: 11.06.2024
(51) Int. Cl.: H01L 21/308, H01L 29/10, H01L 29/08, H01L 29/417, H01L 29/66, H01L 29/78

(54) **SEMICONDUCTOR DEVICE AND MANUFACTURING METHOD THEREOF**

(30) Priority: 30.10.2023 US 202363594035 P; 19.03.2024 TW 113110213
(71) Applicant: Hon Young Semiconductor Corporation, Hsinchu City 300093 (TW)
(72) Inventor: CHEN, Yan-Ru, 300093 Hsinchu City (TW)
(74) Representative: Winter, Brandl - Partnerschaft mbB

(57) **Abstract**

A method includes forming a trench in a substrate, the trench extending downwards from a top surface of the substrate, in which the trench has a sidewall and a bottom surface, and an angle between the sidewall and the bottom surface is greater than or equal to 90 degrees, forming a well region at the top surface of the substrate, the sidewall and the bottom surface of the trench, forming a source region and a body contact region at the bottom surface of the trench, and the body contact region being adjacent to the source region, forming a gate structure along the top surface of the substrate, the sidewall and the bottom surface of the trench, and forming a source contact in the trench to penetrate the gate structure and electrically connect to the source region and the body contact region.

## Description

### BACKGROUND

### Field of Disclosure

The present disclosure relates to a semiconductor device and manufacturing method thereof.

### Description of Related Art

Metal oxide semiconductor field effect transistors (MOSFETs) can be classified into horizontal-channel MOSFETs and vertical-channel MOSFETs according to the channel direction thereof. The vertical-channel MOSFETs can provide the same current with a relatively small area while obtaining a relatively low on-resistance, thereby remarkably reducing the production cost. Thus, further improving the efficacy of vertical-channel MOSFETs has also become one of important issues.

### SUMMARY

Some embodiments of the present disclosure provide a method of forming a semiconductor device including forming a trench in a substrate, the trench extending downwards from a top surface of the substrate, in which the trench has a sidewall and a bottom surface, and an angle between the sidewall and the bottom surface is greater than or equal to 90 degrees, forming a well region at the top surface of the substrate, the sidewall and the bottom surface of the trench, forming a source region at the bottom surface of the trench, forming a body contact region at the bottom surface of the trench, and the body contact region being adjacent to the source region, forming a gate structure along the top surface of the substrate, the sidewall and the bottom surface of the trench, and forming a source contact in the trench to penetrate the gate structure and electrically connect to the source region and the body contact region.

Some embodiments of the present disclosure provide a semiconductor device includes a substrate, a gate structure, a source contact, and a drain electrode. The substrate has a trench extending downwards from a top surface of the substrate, and the trench has a sidewall and a bottom surface, and an angle between the sidewall and the bottom surface is greater than or equal to 90 degrees. The gate structure is over the substrate and along the top surface of the substrate, the sidewall and the bottom surface of the trench. The source contact is in the trench of the substrate and penetrates the gate structure to electrically connect to a source region of the substrate. The drain electrode is below the substrate.

### BRIEF DESCRIPTION OF THE DRAWINGS

The disclosure can be more fully understood by reading the following detailed description of the embodiment, with reference made to the accompanying drawings as follows:
Figs. 1-6 illustrate cross-section views of a manufacturing method of a semiconductor device in some embodiments of the present disclosure.
Fig. 7 illustrates a cross-section view of a semiconductor device in some other embodiments of the present disclosure.

### DETAILED DESCRIPTION

Some embodiments of the present disclosure are related to a manufacturing method of a vertical-channel power semiconductor device. The vertical-channel power semiconductor device can provide larger current in the same area, thereby obtaining a lower on-resistance.

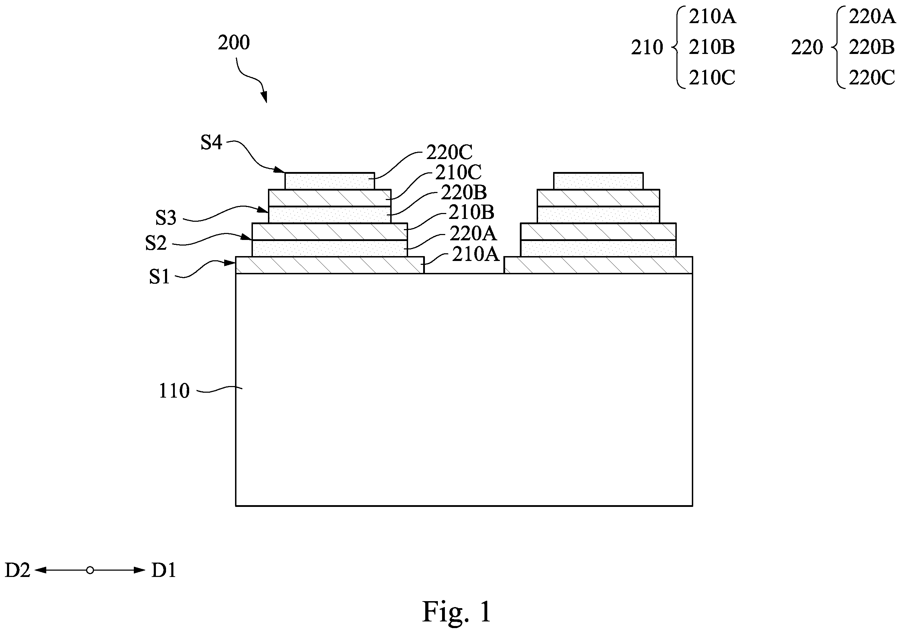

Figs. 1-6 illustrate cross-section views of a manufacturing method of a semiconductor device in some embodiments of the present disclosure. Referring to Fig. 1, a substrate 110 is provided. The substrate 110 may be any suitable semiconductor substrate. For example, the substrate 110 may be silicon substrate or silicon carbide substrate. In some embodiments, the substrate 110 is a lightly doped region of a first semiconductor type. For example, the substrate 110 may be an N-type lightly doped region and includes N-type dopants, such as arsenic, phosphorous and nitrogen.

Subsequently, a dielectric layer stack is formed over the substrate 110. The dielectric layer stack includes a plurality of first dielectric layers 210 and a plurality of second dielectric layers 220 alternately stacked. The first dielectric layers 210 are made of a first material, and the second dielectric layers 220 are made of a second material different from the first material. In some embodiments, the first dielectric layers 210 may be made of silicon oxide, and the second dielectric layers 220 may be made of silicon nitride. In some embodiments, the thickness of the first dielectric layers 210 and the second dielectric layers 220 may be between 0.1 µm and 0.5 µm respectively. In some embodiments, the dielectric layer stack may include 2 to 10 layers of the first dielectric layers 210 and the second dielectric layers 220 respectively. In the later description, the present disclosure takes the dielectric layer stack including the first dielectric layers 210A, 210B and 210C and the second dielectric layers 220A, 220B and 220C as an example.

Subsequently, a first patterning process is performed through a photomask to pattern the dielectric layer stack, and the dielectric layer stack has a first sidewall S1. Specifically, a first photoresist layer is first formed over the dielectric layer stack, and the first photoresist layer is patterned through a photomask. Subsequently, the entire dielectric layers in the dielectric layer stack are patterned through the first photoresist layer. At this time, the photomask is at a first location.

Subsequently, the photomask is moved along a first direction D1, and a second patterning process is performed through the photomask to partially pattern the dielectric layer stack, such that the dielectric layer stack has the first sidewall S1 and a second sidewall S2 shifted towards the first direction D1, and the second sidewall S2 is over the first sidewall S1. Specifically, a second photoresist is formed over the dielectric layer stack, and the photomask is moved along the first direction D1 based on the first location. The photomask is at a second location accordingly, and the second photoresist layer is patterned through the photomask. The second photoresist layer is shifted by a distance towards the first direction D1 compared with the first photoresist layer. Subsequently, the second dielectric layer 220C is etched by using a first gas and by using the second photoresist layer as mask, and then the first dielectric layer 210C is etched by using a second gas and by using the second dielectric layer 220C as mask. Since the second dielectric layers 220 and the first dielectric layers 210 are made of different material, different etching gas may be chosen to etch the first dielectric layers 210 and the second dielectric layers 220 respectively. In the present disclosure, the first gas is defined as the gas etching the second dielectric layers 220 at a faster rate than etching the first dielectric layers 210. The second gas is defined as the gas etching the first dielectric layers 210 at a faster rate than etching the second dielectric layers 220.

Subsequently, the photomask is moved along a first direction D1, and a third patterning process is performed through the photomask to partially pattern the dielectric layer stack, such that the dielectric layer stack further has a third sidewall S3. The third sidewall S3 is shifted towards the first direction D1 compared with the second sidewall S2 and the first sidewall S1, and the third sidewall S3 is over the second sidewall S2. Specifically, a third photoresist is formed over the dielectric layer stack, and the photomask is moved along the first direction D1 based on the second location. The photomask is at a third location accordingly, and the third photoresist layer is patterned through the photomask. The third photoresist layer is shifted by a distance towards the first direction D1 compared with the second photoresist layer. Subsequently, the first gas is used to etch the second dielectric layer 220C and the second dielectric layer 220B by using the third photoresist layer and the first dielectric layer 210C as mask respectively, and then the second gas is used to etch the first dielectric layer 210C and the first dielectric layer 210B by using the second dielectric layer 220C and the second dielectric layer 220B as mask respectively.

Subsequently, the photomask is moved along a first direction D1, and a fourth patterning process is performed through the photomask to partially pattern the dielectric layer stack, such that the dielectric layer stack further has a fourth sidewall S4. The fourth sidewall S4 is shifted towards the first direction D1 compared with the third sidewall S3, and the fourth sidewall S4 is over the third sidewall S3. Specifically, a fourth photoresist is formed over the dielectric layer stack, and the photomask is moved along the first direction D1 based on the third location. The photomask is at a fourth location accordingly, and the fourth photoresist layer is patterned through the photomask. The fourth photoresist layer is shifted by a distance towards the first direction D1 compared with the third photoresist layer. Subsequently, the first gas is used to etch the second dielectric layer 220C, the second dielectric layer 220B and the second dielectric layer 220A by using the fourth photoresist layer, the first dielectric layer 210C and the first dielectric layer 2108 as mask respectively. As a result, the sidewall of one of the sides of the dielectric layer stack is formed in staircase-shaped.

Subsequently, the sidewall of the other side of the dielectric layer stack is also formed in staircase-shaped in a similar process mentioned previously (for example, the photomask mentioned previously is moved along a second direction D2 from the first location), and thus a plurality of staircase-shaped dielectric layer stacks 200 are formed over the substrate 110. In the present disclosure, the photomask may be used to pattern the dielectric layer stack to form the staircase-shaped dielectric layer stacks 200. The shape of the sidewall of the staircase-shaped dielectric layer stacks 200 may be determined by the distance of moving the photomask each time. Moreover, the shift distances of the second photoresist layer, the third photoresist layer and the fourth photoresist layer corresponds with the distance of moving the photomask each time. The staircase-shaped dielectric layer stacks 200 includes the first sidewall S1, the second sidewall S2, the third sidewall S3 and the fourth sidewall S4 shifted inwards sequentially. In some embodiments, the horizontal distance between the two adjacent sidewalls (such as the horizontal distance between the first sidewall S1 and the second sidewall S2, the horizontal distance between the second sidewall S2 and the third sidewall S3, the horizontal distance between the third sidewall S3 and the fourth sidewall S4) may be between 0.1 µm and 0.5 µm. The staircase-shaped dielectric layer stacks 200 include a plurality of first dielectric layers 210 and a plurality of second dielectric layers 220 alternately stacked. The first dielectric layers 210 are made of a first material, and the second dielectric layers 220 are made of a second material different from the first material. In some embodiments, the first dielectric layers 210 may be made of silicon oxide, and the second dielectric layers 220 may be made of silicon nitride. In some embodiments, the thickness of the first dielectric layers 210 and the second dielectric layers 220 may be between 0.1 µm and 0.5 µm respectively. In some embodiments, the dielectric layer stack may include 2 to 10 layers of the first dielectric layers 210 and the second dielectric layers 220 respectively.

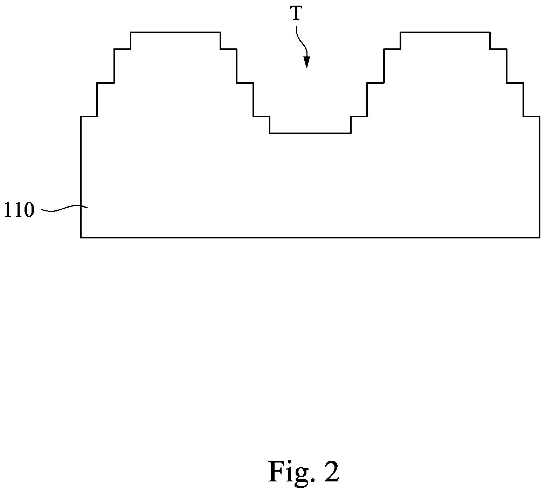

Referring to Fig. 2, a trench T is formed in the substrate 110. Specifically, the substrate 110 is etched to form the trench T by using the staircase-shaped dielectric layer stacks 200 as masks. During etching the substrate 110 by using the staircase-shaped dielectric layer stacks 200 as masks, the staircase-shaped dielectric layer stacks 200 and the substrate 110 are etched at a same etching rate until the staircase-shaped dielectric layer stacks 200 are entirely etched. Therefore, the staircase-shaped trench T is formed in the substrate 110.

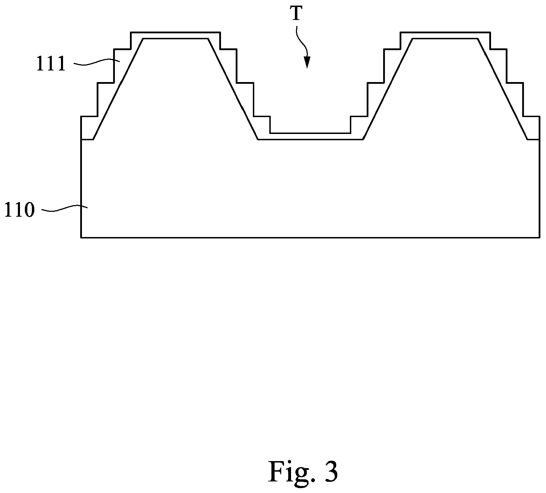

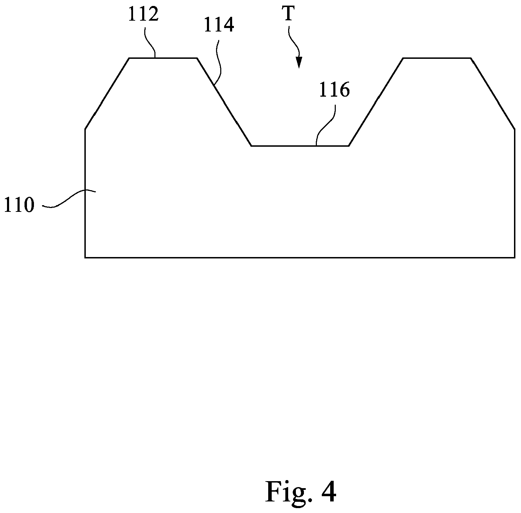

After forming the staircase-shaped trench T, a smoothening process is performed to the substrate 110, such that the surface of the substrate 110 becomes smooth. In some embodiments, referring to Fig. 3, an oxidation process is first performed to the substrate 110 to form an oxide layer 111 at the surface of the substrate 110. Subsequently, referring to Fig. 4, the oxide layer 111 is removed, such that the surface of the substrate 110 becomes smooth. After the smoothening process, the trench T extends downwards from a top surface 112 of the substrate 110, and the trench T has a sidewall 114 and a bottom surface 116, and an angle between the sidewall 114 and the bottom surface 116 is greater than 90 degrees. Stated another way, the trench T is an inverted trapezoidal trench.

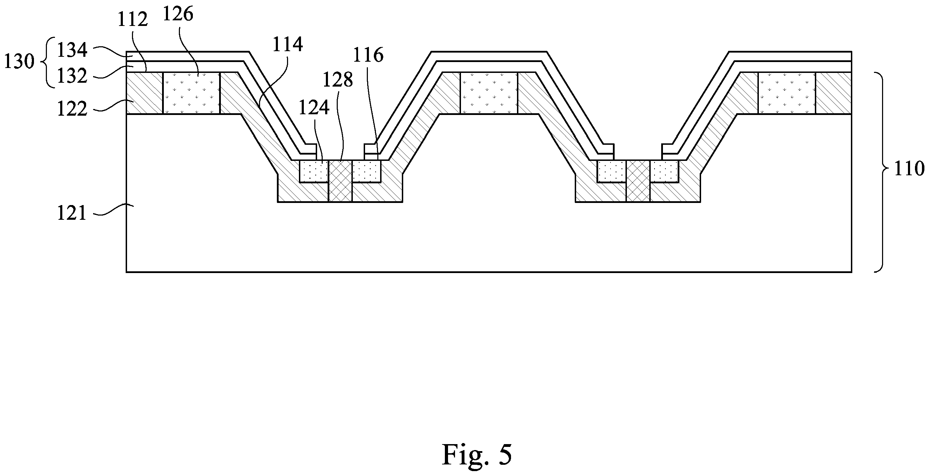

Referring to Fig. 5, a first ion implantation process is performed to the substrate 110 to form a well region 122 at the top surface 112 of the substrate 110 and the sidewalls 114 and the bottom surfaces 116 of the trenches T. Specifically, during performing the first ion implantation process, dopants of the second semiconductor type are implanted into the substrate 110 to form the well region 122 of second semiconductor type at the top surface 112 of the substrate 110 and the sidewalls 114 and the bottom surfaces 116 of the trenches T. In some embodiments, the well region 122 may be a lightly doped region of the second semiconductor type. For example, the well region 122 may be a P-type lightly doped region, and includes P-type dopants such as boron, gallium and aluminum. The region not doped with dopants of the second semiconductor type remains as a doped region of the first semiconductor type, and such doped region of the first semiconductor type is referred to as a drift region 121. The doping concentration of the well region 122 is higher than a doping concentration of the drift region 121.

Subsequently, a second ion implantation process is performed to the substrate 110 to form source regions 124 at the bottom surfaces 116 of the trenches T. Specifically, during performing the second ion implantation process, dopants of the first semiconductor type are implanted into the substrate 110 to form the source regions 124 of first semiconductor type at the bottom surfaces 116 of the trenches T. In some embodiments, the source regions 124 may be heavily doped regions of the first semiconductor type. For example, the source regions 124 may be N-type heavily doped regions, and includes N-type dopants such as arsenic, phosphorous and nitrogen.

After forming the source regions 124, junction field-effect transistor (JFET) regions 126 are formed at the top surface 112 of the substrate 110, and the JFET regions 126 and the source regions 124 have the same semiconductor type and doping concentration. In some embodiments, the JFET regions 126 may be heavily doped regions of the first semiconductor type. For example, the JFET regions 126 may be N-type heavily doped regions, and includes N-type dopants such as arsenic, phosphorous and nitrogen.

Subsequently, a third ion implantation process is performed to the substrate 110 to form body contact regions 128 at the bottom surfaces 116 of the trenches T, and the body contact regions 128 are adjacent to the source regions 124. Specifically, during performing the third ion implantation process, dopants of the second semiconductor type are implanted into the substrate 110 to form the body contact regions 128 of second semiconductor type at the bottom surfaces 116 of the trenches T. In some embodiments, the body contact regions 128 may be heavily doped regions of the second semiconductor type, and the doping concentration of the body contact regions 128 is higher than the doping concentration of the well region 122. For example, the body contact regions 128 may be P-type lightly doped regions, and include P-type dopants such as boron, gallium and aluminum.

Subsequently, gate structures 130 is formed along the top surface 112 of the substrate 110 and the sidewalls 114 and the bottom surfaces 116 of the trenches T. In some embodiments, each of the gate structures 130 may have a first horizontal portion over the top surface 112 of the substrate 110, an inclined portion at the sidewall 114 of the trench T, and a second horizontal portion at bottom surface 116 of the trench T. Specifically, a gate dielectric layer 132 is first formed over the substrate 110 and along the top surface 112 of the substrate 110, the sidewalls 114 and the bottom surfaces 116 of the trenches T. Subsequently, a gate layer 134 is formed over the gate dielectric layer 132. The gate dielectric layer 132 and the gate layer 134 are collectively referred to as the gate structure 130. Subsequently, openings are formed in the gate structure 130 to expose the body contact regions 128 and a portion of the source regions 124. In some embodiments, the gate dielectric layer 132 may be made of silicon oxide, and the gate layer 134 may be made of polysilicon.

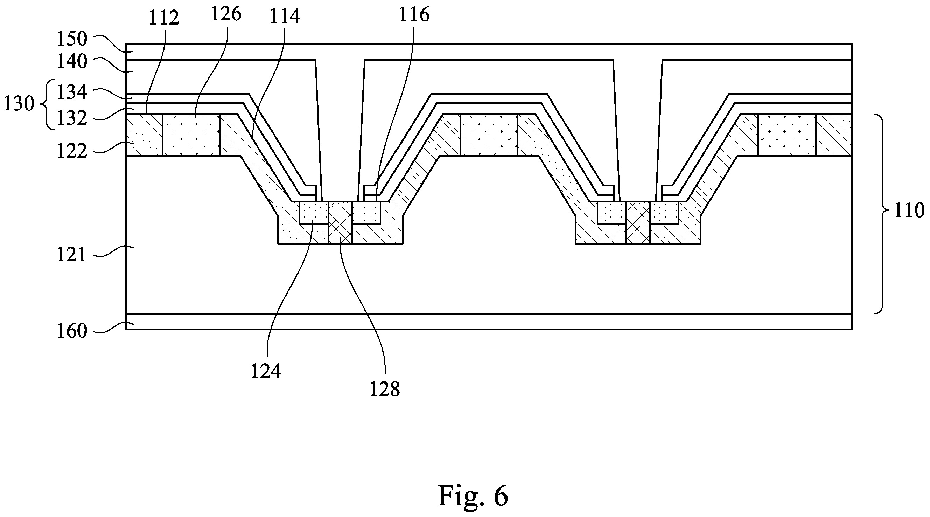

Referring to Fig. 6, a dielectric layer 140 is formed over the substrate 110 and in the trenches T. The dielectric layer 140 also fills the openings of the gate structures 130. Subsequently, the source contact 150 is formed in the trenches T to penetrate the gate structures 130 and electrically connect to the source regions 124 and the body contact regions 128. Specifically, openings are first formed in the dielectric layer 140 to expose the source regions 124 and the body contact regions 128. Subsequently, a contact material is filled in the openings to form the source contact 150. Therefore, the source contact 150 penetrates the dielectric layer 140 and the gate structures 130 and is in contact with the source regions 124 and the body contact regions 128, and the dielectric layer 140 surrounds the source contact 150. Subsequently, a drain electrode 160 is formed below the substrate 110.

As a result, a semiconductor device shown in Fig. 6 is obtained. The semiconductor device includes the substrate 110, the gate structures 130, the source contact 150 and the drain electrode 160. The substrate 110 has trenches T (see Fig. 4) extending downwards from a top surface 112 of the substrate 110, and each of the trenches T has a sidewall 114 and a bottom surface 116, and an angle between the sidewall 114 and the bottom surface 116 is greater than 90 degrees. The substrate 110 includes the drift region 121, the well regions 122, the JFET regions 126, the body contact regions 128 and the source regions 124. The well regions 122 are over the drift region 121, and the well regions 122 are along the top surface 112 of the substrate 110, the sidewalls 114 and the bottom surfaces 116 of the trenches T. The JFET regions 126 are at the top surface 112 of the substrate 110. The source regions 124 are at the bottom surfaces 116 of the trenches T. The body contact regions 128 are at the bottom surfaces 116 of the trenches T and adjacent to the source regions 124. The gate structures 130 are over the substrate 110 and along the top surface 112 of the substrate 110, the sidewalls 114 and the bottom surfaces 116 of the trenches T. The source contact 150 is in the trenches T of the substrate 110, and penetrates the gate structures 130 to electrically connect to the source regions 124 and the body contact regions 128. The drain electrode 160 is below the substrate 110.

The semiconductor device in the present disclosure has vertical channels, and the vertical channels are the well regions 122 along the sidewalls 114 of the trenches T. If the semiconductor device has the vertical channels, such as the angle between the sidewall 114 and the bottom surface 116 is greater than 90 degrees, larger current is provided in the same area, thereby obtaining a lower on-resistance. Moreover, the angle between the sidewall 114 and the bottom surface 116 is determined based on a direction of lattice arrangement of the substrate 110. Specifically, the angle between the sidewall 114 and the bottom surface 116 can determine the extending direction of the well regions 122 along the sidewalls 114 (i.e. the direction of the channel). When the direction of the channel is same as the direction of the lattice arrangement of the substrate 110, the carriers in the channel have the highest carrier mobility. Stated another way, the angle between the sidewall 114 and the bottom surface 116 is determined based on a direction of lattice arrangement of the substrate 110 to ensure that the carriers in the channel have the highest carrier mobility, and thus have the largest current (for example, when the extending direction of the sidewalls 114 is same as the direction of the lattice arrangement of the substrate 110). Since a portion of the gate structures 130 is formed along the sidewalls 114 of the trenches T, when the extending direction of the sidewalls 114 of the trenches T is same as the direction of the lattice arrangement of the substrate 110. The direction of the gate structures 130 extending over the sidewalls 114 of the trenches T is also same as the direction of the lattice arrangement of the substrate 110.

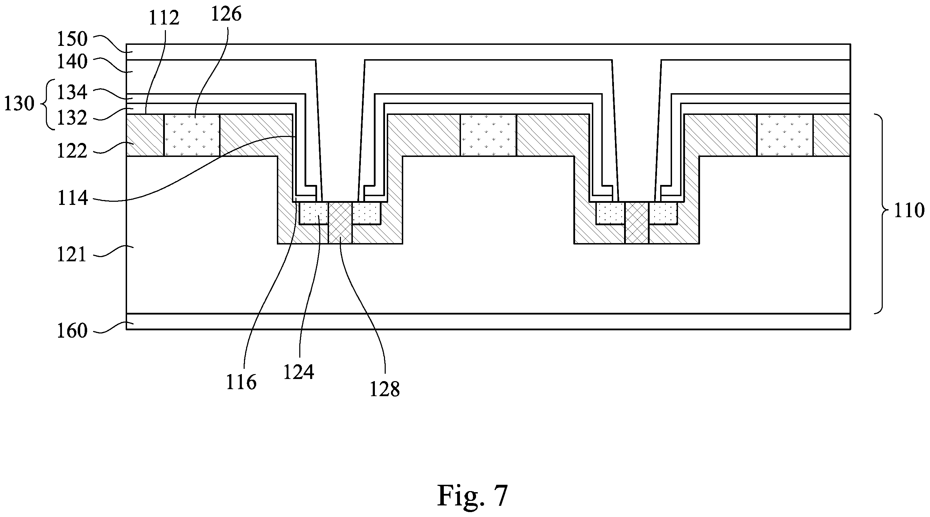

Fig. 7 illustrates a cross-section view of a semiconductor device in some other embodiments of the present disclosure. The semiconductor device in Fig. 7 is similar to the semiconductor device in Fig. 6. The difference between the two is that the angle between the sidewall 114 and the bottom surface 116 of the trench in Fig. 7 is 90 degrees. When forming the semiconductor device in Fig. 7, the staircase-shaped dielectric layer stack in Fig. 1 is replaced with the hard mask layer with vertical sidewalls, and the hard mask layer with vertical sidewalls is used to etch the substrate 110. Subsequently, the processes in Figs. 2-6 are performed to form the semiconductor device in Fig. 7. If the angle between the sidewall 114 and the bottom surface 116 of the trenches of the semiconductor device is 90 degrees, larger current is also provided in the same area, thereby obtaining a lower on-resistance.

## Claims

1. A method of manufacturing a semiconductor device, comprising:
forming a trench (T) in a substrate (110), the trench (T) extending downwards from a top surface (112) of the substrate (110), wherein the trench (T) has a sidewall (114) and a bottom surface (116), and an angle between the sidewall (114) and the bottom surface (116) is greater than or equal to 90 degrees;
forming a well region (122) at the top surface (112) of the substrate (110), the sidewall (114) and the bottom surface (116) of the trench (T);
forming a source region (124) at the bottom surface (116) of the trench (T);
forming a body contact region (128) at the bottom surface (116) of the trench (T), and the body contact region (128) being adjacent to the source region (124);
forming a gate structure (130) along the top surface (112) of the substrate (110), the sidewall (114) and the bottom surface (116) of the trench (T); and
forming a source contact (150) in the trench (T) to penetrate the gate structure (130) and electrically connect to the source region (124) and the body contact region (128).

2. The method of claim 1, wherein the trench (T) is an inverted trapezoidal trench.

3. The method of claim 1 or 2, wherein forming the trench (T) in the substrate (110) comprises:
forming a plurality of staircase-shaped dielectric layer stacks (200) over the substrate (110); and
etching the substrate (110) to form the trench (T) by using the staircase-shaped dielectric layer stacks (200) as masks.

4. The method of claim 3, wherein forming the staircase-shaped dielectric layer stacks (200) over the substrate (110) comprises:
forming a dielectric layer stack over the substrate (110), the dielectric layer stack comprising a plurality of first dielectric layers (210) and a plurality of second dielectric layers (220) alternately stacked, wherein the first dielectric layers (210) are made of a first material, and the second dielectric layers (220) are made of a second material different from the first material; and
patterning the dielectric layer stack by a photomask multiple times to form the staircase-shaped dielectric layer stacks (200).

5. The method of claim 3 or 4, wherein during etching the substrate (110) by using the staircase-shaped dielectric layer stacks (200) as the masks, the staircase-shaped dielectric layer stacks (200) and the substrate (110) are etched at a same etching rate.

6. The method of claim 1, 2, 3, 4 or 5, wherein the angle between the sidewall (114) and the bottom surface (116) is determined based on a direction of lattice arrangement of the substrate (110).

7. A semiconductor device, comprising:
a substrate (110) having a trench (T) extending downwards from a top surface (112) of the substrate (100), wherein the trench (T) has a sidewall (114) and a bottom surface (116), and an angle between the sidewall (114) and the bottom surface (116) is greater than or equal to 90 degrees;
a gate structure (130) over the substrate (110) and along the top surface (112) of the substrate(110), the sidewall (114) and the bottom surface (116) of the trench (T);
a source contact (150) in the trench (T) of the substrate (110) and penetrating the gate structure (130) to electrically connect to a source region (124) of the substrate (110); and
a drain electrode (160) below the substrate (110).

8. The semiconductor device of claim 7, wherein the trench (T) is an inverted trapezoidal trench.

9. The semiconductor device of claim 7 or 8, further comprising:
a well region (122) along the top surface (112) of the substrate (110), the sidewall (114) and the bottom surface (116) of the trench (T); and
a body contact region (128) at the bottom surface (116) of the trench (T), and the body contact region (128) being adjacent to the source region (124).

10. The semiconductor device of claim 7, 8 or 9, wherein an extending direction of the sidewall (114) of the trench (T) is same as a direction of lattice arrangement of the substrate (110).

11. The semiconductor device of claim 7, 8, 9 or 10, wherein an extending direction of the gate structure (130) over the sidewall of trench (T) is same as a direction of lattice arrangement of the substrate (110).
